# EUROPEAN PATENT APPLICATION

(11) **EP 4 376 070 A1**
(43) Date of publication of application: **29.05.2024**
(21) Application number: 23212198.8
(22) Date of filing: 27.11.2023
(51) Int. Cl.: H01L 23/31, H01L 23/36, H01L 23/367, H01L 23/373, H01L 23/433

(54) **SEMICONDUCTOR PACKAGE WITH INSERT**

(30) Priority: 28.11.2022 US 202217994743
(71) Applicant: Infineon Technologies Austria AG, 9500 Villach (AT)
(72) Inventor: SCHWAB, Stefan, 93053 Regensburg (DE); JÜRSS, Michael, 93105 Tegernheim (DE); SCHARF, Thorsten, 93138 Lappersdorf - Kareth (DE)
(74) Representative: Lambsdorff & Lange Patentanwälte Partnerschaft mbB

(57) **Abstract**

A semiconductor package includes a semiconductor die thermally coupled to a planar metal pad, an encapsulant body that encapsulates the semiconductor die and includes a recess that extends from an outer upper side of the encapsulant body towards a rear side of the planar metal pad, and an insert arranged within the recess that is thermally coupled to the planar metal pad and extends to the outer upper side of the encapsulant body, wherein the insert that is arranged within the recess includes a curable polymer compound.

## Description

### BACKGROUND

Semiconductor packages can be configured to dissipate heat by thermally coupling the die to a heat sink. One possible semiconductor package configuration has an exposed die pad at its rear surface so the die pad can be directly thermally coupled to a heat sink. However, in some cases an exposed die pad is not possible because the die pad is connected to an electrical potential and therefore must be electrical isolated. Current approaches to solving this problem suffer from various drawbacks including unwanted process variation and increased time and expense in board assembly.

### SUMMARY

A semiconductor package is disclosed. According to an embodiment, the semiconductor package comprises a semiconductor die thermally coupled to a planar metal pad, an encapsulant body that encapsulates the semiconductor die and comprises a recess that extends from an outer upper side of the encapsulant body towards a rear side of the die pad, and an insert arranged within the recess that is thermally coupled to the die pad and extends to the outer upper side of the encapsulant body, wherein the insert that is arranged within the recess comprises a curable polymer compound.

A method of forming a semiconductor package is disclosed. According to an embodiment, the method comprises thermally coupling a semiconductor die to a planar metal pad, forming an encapsulant body that encapsulates the semiconductor die and comprises a recess that extends from an outer upper side of the encapsulant body towards a rear side of the die pad, and providing an insert within the recess that is thermally coupled to the die pad and extends to the outer upper side of the encapsulant body, wherein the insert that is arranged within the recess comprises a curable polymer compound.

A method of assembling an electronics device is disclosed. According to an embodiment, the method comprises providing a plurality of semiconductor packages, each of the semiconductor packages comprising a semiconductor die thermally coupled to a planar metal pad, an encapsulant body that encapsulates the semiconductor die, a plurality of leads exposed from the encapsulant body, a recess that extends from an outer upper side of the encapsulant body towards a rear side of the die pad, and an insert arranged within the recess that is thermally coupled to the die pad and extends to the outer upper side of the encapsulant body, providing a circuit carrier that comprises a plurality of contact pads disposed on an upper side of the circuit carrier, arranging the plurality of semiconductor packages on the circuit carrier with the leads facing the contact pads and with the outer upper sides of each of the encapsulant bodies facing away from the circuit carrier, arranging a heat sink over the plurality of semiconductor packages such that the heat sink contacts at least some of the inserts, and joining the heat sink to each of the inserts so as to form a thermally coupled connection between the heat sink and each of the semiconductor packages, wherein joining the heat sink to each of the inserts comprises flowing material from the inserts laterally away from the recesses.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
Figure 1, which includes Figs. 1A and 1B, depicts a semiconductor package with a recess configured to receive an insert, according to an embodiment. Fig. 1A depicts a cross-sectional view of the semiconductor package; and Fig. 1B depicts a plan-view of the semiconductor package.
Figure 2, which includes Figs. 2A and 2B, depicts a semiconductor package with an insert provided within the recess, according to an embodiment. Fig. 2A depicts a cross-sectional view of the semiconductor package; and Fig. 2B depicts a plan-view of the semiconductor package.
Figure 3, which includes Figs. 3A, 3B and 3C, depicts a method of assembling an electronics device, according to an embodiment. Fig. 3A depicts arranging a plurality of semiconductor packages on a circuit carrier; Fig. 3B depicts arranging a heat sink over the inserts of the semiconductor packages; and Fig. 3C depicts the assembly after flowing the material of the heat sink to attach the heat sink to each of the semiconductor packages.
Figure 4, which includes Figs. 4A and 4B, depicts a semiconductor package with an insert provided within the recess, according to an embodiment. Fig. 4A depicts a cross-sectional view of the semiconductor package according to one embodiment; and Fig. 4B depicts a cross-sectional view of the semiconductor package according to another embodiment.
Figure 5 depicts a depicts a cross-sectional view of a semiconductor package with an insert provided within the recess, according to another embodiment

### DETAILED DESCRIPTION

Embodiments of a semiconductor package, a method of forming the semiconductor package, and a method of assembling a plurality of the semiconductor packages are disclosed herein. The semiconductor package comprises a semiconductor die mounted on a die pad that is encapsulated by an encapsulant body. A recess is formed in the encapsulant body that exposes a rear side of the die pad. An insert is provided within the recess that is thermally coupled to the die pad and hence to the semiconductor die mounted thereon. The insert may completely fill the recess and protrude past an outer upper side of the encapsulant body. The insert comprises a curable polymer compound, e.g., thermoset polymer, UV curable polymer, moisture curable polymer, catalytic polymer, etc. In the method of assembling a plurality of the semiconductor packages, a group of the semiconductor packages each having this insert configuration can be mounted on a single carrier structure. Advantageously, the semiconductor packages can have height variations relative to the circuit carrier, and a multi-device heat sink can nevertheless mate with each semiconductor package along a single plane. This is because the curable polymer compound can be flowed and redistributed to and eliminate any height discrepancy and form a planar mating interface between each semiconductor package and the heat sink. Concurrently or simultaneously, the curable polymer compound can be cured to form a hardened attachment interface.

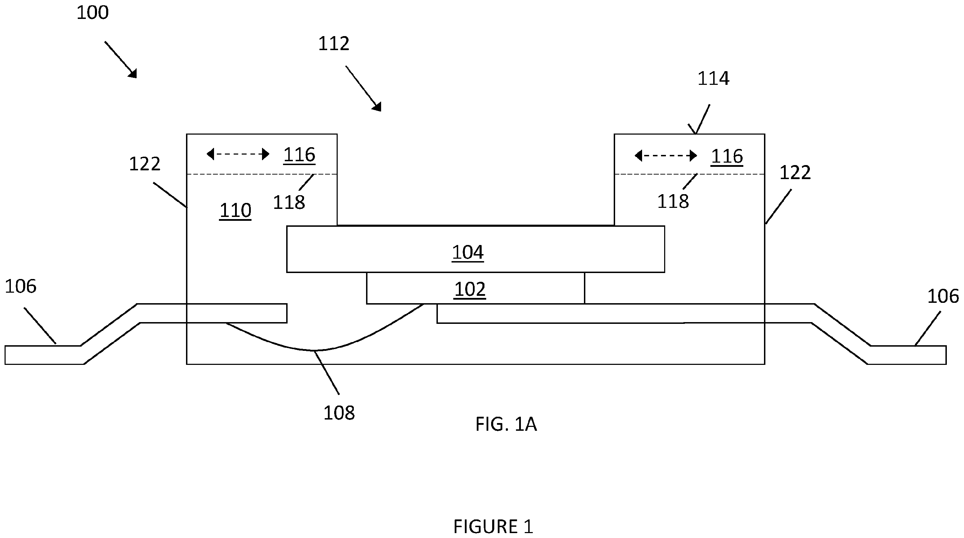

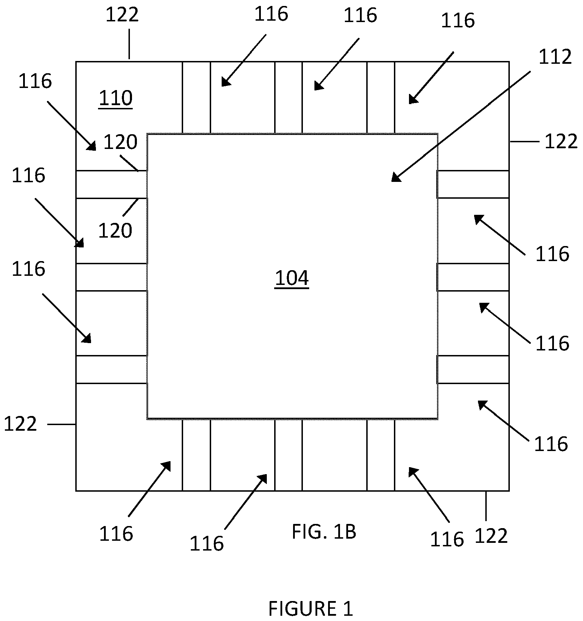

Referring to Figure 1, a semiconductor package 100 is depicted, according to an embodiment. The semiconductor package 100 comprises a semiconductor die 102. Generally speaking, the semiconductor die 102 can be any of a wide variety of device types, e.g., discrete device, logic device, passive device, sensor, etc. According to an embodiment, the semiconductor die 102 is configured as a power device that is rated to withstand voltages of at least 100V (volts), and more typically voltages of 600V, 1200V or more and/or is rated to accommodate currents of at least 1A, and more typically currents of 10A, 50A, 100A or more. Examples of power devices include discrete power diodes and discrete power transistor dies, e.g., MOSFETs (Metal Oxide Semiconductor Field Effect Transistors), IGBTs (Insulated Gate Bipolar Transistors), and HEMTs (High Electron Mobility Transistors), etc.

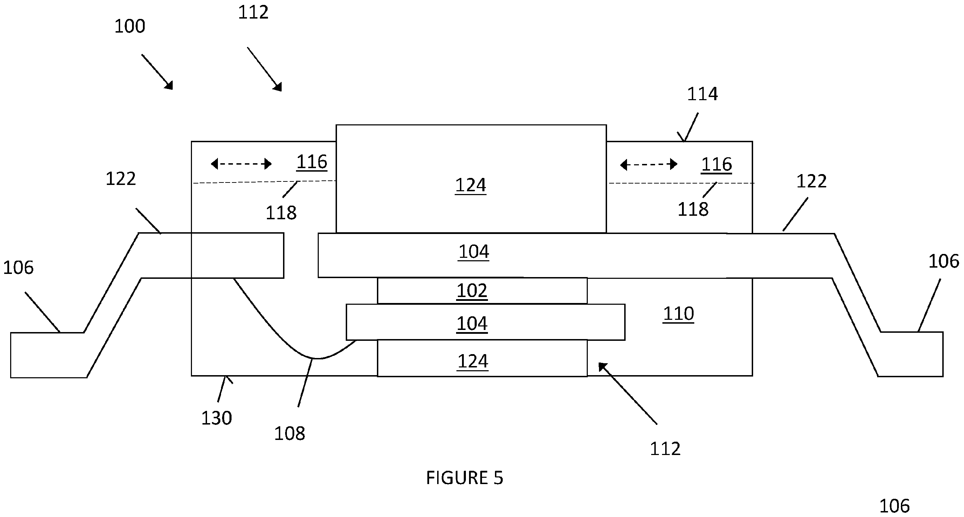

The semiconductor package 100 comprises a planar metal pad 104 and a plurality of package leads 106. The planar metal pad 104 and the package leads 106 can be provided formed of a conducive metal, e.g., copper, nickel, aluminum, etc., and alloys or combinations thereof. The semiconductor die 102 is thermally coupled to the planar metal pad 104. This may be done using an adhesive, e.g., solder, sinter, glue, tape, etc. Terminals of the semiconductor die 102 are electrically connected to the package leads 106. In the depicted embodiment, the planar metal pad 104 is a metal die pad that is electrically isolated within the encapsulant body 110 and the semiconductor die 102 is mounted on this die pad with upper surface terminals facing away from the die pad. The upper surface terminals of the semiconductor die 102 are electrically connected to the package leads 106. As shown, at least some of these electrical connections are provided by bond wires 108. Other types of electrical interconnect elements, e.g., metal clips, ribbon, etc., may be used instead to provide these electrical connections. As shown, one of the package leads 106 is directly electrically connected to an upper surface terminal of the semiconductor die 102 via a package lead 106 that is configured as a clip connector. In that case, the semiconductor die 102 can be configured as a lateral device, wherein the rear surface connection between the die and the planar metal pad 104 does not form a terminal connection. In other embodiments, the semiconductor die 102 can be configured as a vertical device with a load terminal, e.g., source, drain, collector, emitter, etc., disposed at a rear side of the semiconductor die. In that case, the planar metal pad 104 can form a continuous connection with a package lead 106 (e.g., as shown in Fig. 5) or be electrically connected to a package lead 106 by an electrical interconnect element.

The semiconductor package 100 comprises an encapsulant body 110 that encapsulates the semiconductor die 102. The encapsulant body 110 is formed from an electrically insulating material that surrounds and protects the semiconductor die 102 and associated electrical connections. The encapsulant body 110 can comprise any of a wide variety of electrical insulators that are suitable package materials, e.g., mold compound, epoxy, polymer, ceramic, glass-woven fiber materials, etc. According to an embodiment, the encapsulant body 110 is formed by a molding technique, e.g., injection molding, compression molding, transfer molding, etc. In that case, the encapsulant body 110 can comprise a mold compound. Alternatively, the encapsulant body 110 can be formed by a lamination technique whereby multiple layers of laminate material, e.g., a glass-woven fiber such as FR-4, are successively stacked on top of one another.

Outer ends of the package leads 106 are exposed from the encapsulant body 110, thus forming externally accessible points of electrical contact to the semiconductor package 100. The depicted package configuration corresponds to a so-called surface mount package type. The insert concept described herein is more generally applicable to a wide variety of package types, including so-called flat packages, leadless packages, through-hole packages, etc.

The encapsulant body 110 of the semiconductor package 100 comprises a recess 112 that extends from an outer upper side 114 of the encapsulant body 110 towards a rear side of the planar metal pad 104, which in turn is opposite from the upper side of the planar metal pad 104 to which the semiconductor die 102 is mounted on. As shown, the recess 112 extends completely to the rear side of the planar metal pad 104, thus exposing the rear side of the planar metal pad 104. Alternatively, the recess 112 may extend partially into the encapsulant body 110 such that a thickness of encapsulant material remains covering the rear side of the planar metal pad 104. The recess 112 therefore removes or at least reduces the amount of encapsulant material from the encapsulant body 110 between the planar metal pad 104 and the exterior environment.

The recess 112 can be formed in a variety of ways. For example, in the case that the encapsulant body 110 is formed by a molding process, the molding chamber can be adapted to form the encapsulant body 110 with the recess 112. Alternatively, the encapsulant body 110 can be initially formed with encapsulant material in the place of the recess 112, and the recess 112 can be formed by removing material, e.g., etching, mechanical grinding, etc.

The recess 112 may have a variety of different geometries. As shown, the recess 112 may have sidewalls that are substantially perpendicular to the outer upper side 114 of the encapsulant body 11 and the rear side of the planar metal pad 104. Alternatively, the sidewalls of the recess 112 may be oriented at an oblique angle relative to the outer upper side 114 and/or the rear side of the planar metal pad 104. Separately or in combination, instead of having acute corners, the recess 112 may have gradual transitions. Separately or in combination, instead of smooth sidewalls, the sidewalls of the recess 112 may comprise features that increase the surface area of the sidewalls and enhance adhesion with the insert 124 to be described below.

According to an embodiment, the encapsulant body 110 comprises one or more overflow channels 116. The location of the bottom surfaces 118 of these overflow channels 116 are shown in Fig. 1A and the sidewalls 120 of the overflow channels 116 is shown in Fig. 1B. The overflow channels 116 each extend vertically into the encapsulant body 110 from the outer upper side 114 of the encapsulant body 110 and extend laterally from the sidewalls of the recess 112 to the outer edge sides 122 of the encapsulant body 110. The overflow channels 116 thus form open passages for ingress and egress of fluid from the recess 112 to the outer edge sides 122 of the encapsulant body 110 along a conduit that is below the outer upper side 114 of the encapsulant body 110. Generally speaking, the depth of the overflow channels 116 can be between 100% and 5% of the depth of the recess 112. According to an embodiment, the depth of the overflow channels 116 is no greater than 25% of the depth of the recess 112.

According to an embodiment, the encapsulant body 110 comprises a plurality of the overflow channels 116 and one of the overflow channels 116 extends between the recess 112 and each one of the outer edge sides 122 of the encapsulant body 110. As a result, the overflow channels 116 are arranged to facilitate ingress and egress of fluid in every direction. The number of overflow channels 116 extending from one of the sidewalls of the recess 112 to one of the outer edge sides 122 may vary, e.g., two, three (as shown), four, five, etc.

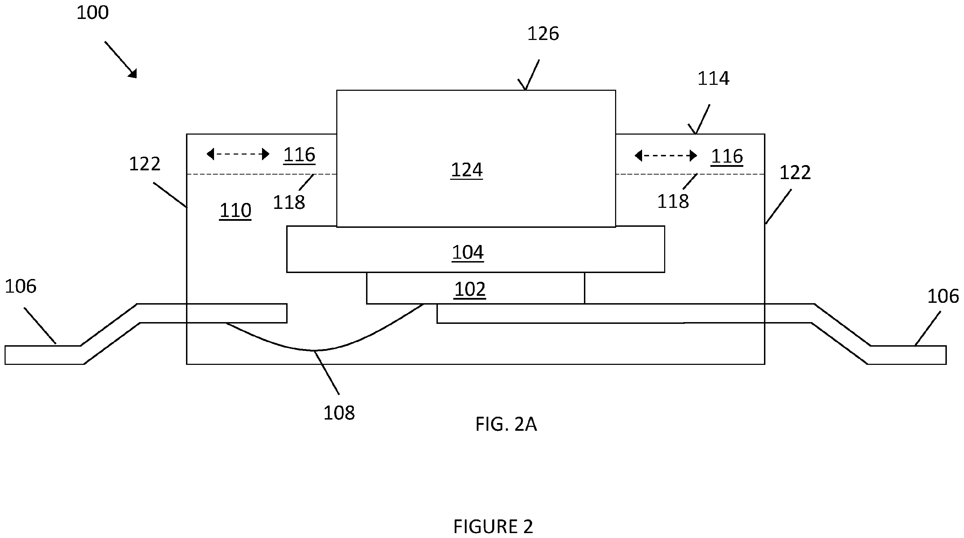

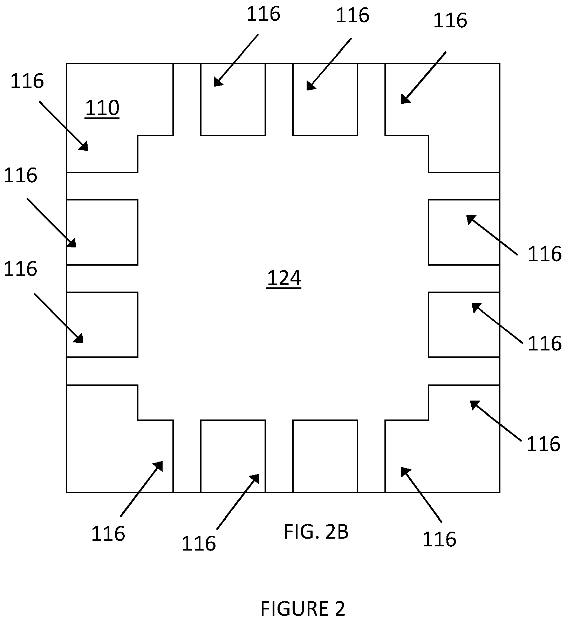

Referring to Figure 2, the semiconductor package 100 comprises an insert 124 arranged within the recess 112. The insert 124 is thermally coupled to the planar metal pad 104. Preferably, the thermal resistance between the insert 124 and the planar metal pad 104 is maintained low such that the insert 124 forms a thermal conduction path between the planar metal pad 104 and the exterior environment. As shown, the insert 124 may directly contact the rear side of the planar metal pad 104 and hence be directly thermally connected to the planar metal pad 104. Alternatively, a thin layer of material may be provided between the insert 124 and the rear side of the planar metal pad 104. For example, as previously mentioned, the recess 112 may not extend completely to the planar metal pad 104 such that a small thickness of material from the encapsulant body 110, e.g., no greater than 50 µm, no greater than 25 µm, no greater than 10 µm, etc. remains. Separately or in combination, a thin layer of material may be provided between the rear side of the planar metal pad 104 and the insert 124, e.g., an adhesive layer, adhesion promoter, etc., that is no greater than 10 µm thick, no greater than 5 µm thick, etc.

According to an embodiment, the insert 124 comprises a curable polymer compound. A curable polymer compound refers to a material that can be irreversibly hardened by a curing process. A curable polymer compound comprises monomers capable of being cross-linked by an external stimulus. The curing process induces a chemical reaction in the material to cross-link the polymers. Thus, a curable polymer compound is a precursor material of hardened plastic material. Before the curing process, the curable polymer compound can be in a liquid or semi-liquid state. For example, the curable polymer compound material can comprise a resin with dynamic viscosity in the range of 1,000 - 50,000 mPa*s (millipascal seconds) at room temperature. Alternatively, the curable polymer compound material can be a powder in a granular or pressed state. Alternatively, the curable polymer compound can be a solid at room temperature with a melting point such that it liquifies during the curing process, thus forming a viscous liquid or quasi-liquid having, e.g., a dynamic viscosity in the range of 1,000 - 50,000 mPa*s, and then returns to a hardened state during the cooling process. According to an embodiment, the curable polymer compound is a thermoset polymer, which refers to a material that is polymerized through the application of heat. According to another embodiment, the curable polymer compound is a UV curable polymer, which refers to a material that is polymerized through the application of ultraviolet light. According to another embodiment, the curable polymer compound is a moisture-cure polymer compound, which refers to a material that is polymerized through the application of water, examples of which include polyurethane prepolymer. According to another embodiment, the curable polymer compound is a catalytic polymer, which refers to a material that is polymerized through exposure to a chemical catalyst such as an acid.

According to an embodiment, the curable polymer compound comprises a matrix of pre-polymerized resin combined with a filler material. The matrix of pre-polymerized resin comprises monomers that are configured to be cured by the above-described cross-linking reaction. The matrix of polymer may be based on an epoxy resin which contains a hydroxyl group, for example. A percent by weight of the matrix of polymer resin in the curable polymer compound may be in the range of 5% to 50%, for example. The filler material may represent a substantial remaining majority of the percent by weight of the curable polymer compound. For example, the percent by weight of the filler material may be in the range of 50% to 95%, with the combined percentage by weight of the pre-polymerized resin and the filler material being in the range of 95% to 100%, for example. The filler material may be used to adjust the properties of the curable polymer compound in one or both of the uncured or cured state, e.g., thermal conductivity, viscosity before curing, coefficient of thermal expansion, melting point after curing, etc. For example, the thermal conductivity of the insert 124 can be increased by incorporated thermally conductive filler materials. The filler material may comprise particles that are intermixed with the matrix of pre-polymerized resin. Examples of the filler materials include crystalline silica, fused silica, spherical silica, titanium oxide, aluminum hydroxide, aluminum oxide, aluminum nitride, silicone nitride, magnesium hydroxide, zirconium dioxide, calcium carbonate, calcium silicate, talc, clay, carbon fiber, glass fiber and mixtures thereof. The curable polymer compound may also comprise a small percentage, e.g., within 1% to 5% percent by weight of the curable polymer compound, of other additive materials. Examples of these materials include adhesion promoters and hardening agents.

The insert 124 may be provided within the recess 112 in a variety of different ways. According to an embodiment, the semiconductor package 100 is formed to comprise the encapsulant body 110 with the recess 112 according to any of the above-described. Subsequently, the insert 124 is formed by a pre-molding step whereby the recess is filled by a mixture of material. According to an embodiment, the mixture of material may comprise a matrix of pre-polymerized resin combined with a thermally conductive filler. In the case of a curable polymer compound that is configured as a semi-liquid, the mixture may be provided within the recess 112 by an injection technique whereby the material is slightly heated to decrease the viscosity of the material, but the material remains below the temperature at which substantial cross-linking of the polymers occur. In the case of a curable polymer compound that is configured as a powder, the mixture may be pressed into the into the recess 112 by means of a stamp. In either case, the curable polymer compound material may be provided within at least a portion of the overflow channels 116. This may result from mechanical pressure being applied to the insert 124 material to force it through the overflow channels 116 or through the natural flow of the material. In any case, the overflow channels 116 advantageously aid in the adhesion of the insert 124 to the encapsulant body 110 by providing an interlocking mechanism. By securely affixing the insert 124 within the recess 112 in a pre-cured state with the proper viscosity, the semiconductor package 100 comprising the insert 124 can be produced by a manufacturer and transported to a downstream assembler that mounts the semiconductor package 100 and cures the curable polymer compound, e.g., according to the technique described below.

The insert 124 is arranged within the recess 112 so as to fill the recess 112 and extend at least to the outer upper side 114 of the encapsulant body 110. As shown, the insert 124 protrudes past the outer upper side 114 of the encapsulant body 110. That is, the insert 124 forms an outermost surface of the semiconductor package 100 that is spaced apart from outer upper side 114 of the encapsulant body 110. According to an embodiment, the insert 124 protrudes past the outer upper side 114 of the encapsulant body 110 by an amount between 50 µm and 1,000 µm (1 mm). More particularly, the insert 124 may protrude past the outer upper side 114 of the encapsulant body 110 by an amount between 100 µm and 200 µm, e.g., about 125 µm to 175 µm. As shown, the upper side 126 of the insert 124 may be substantially planar and parallel to the outer upper side 114 of the encapsulant body 110 such that the insert 124 protrudes by a uniform distance. Alternatively, the upper side 126 of the insert 124 may comprise ridges, rounded edges, warpage, etc. In that case, the distance that the insert 124 protrudes past the outer upper side 114 of the encapsulant body 110 refers to the distance between the outer upper side 114 of the encapsulant body 110 and the highest point of the insert 124 In other embodiments, the insert 124 may be at least level with the upper side 114 of the encapsulant body 110, i.e., with substantially no protrusion. This ensures that the recess 112 is filled and that there is thermal coupling to the planar metal pad 104.

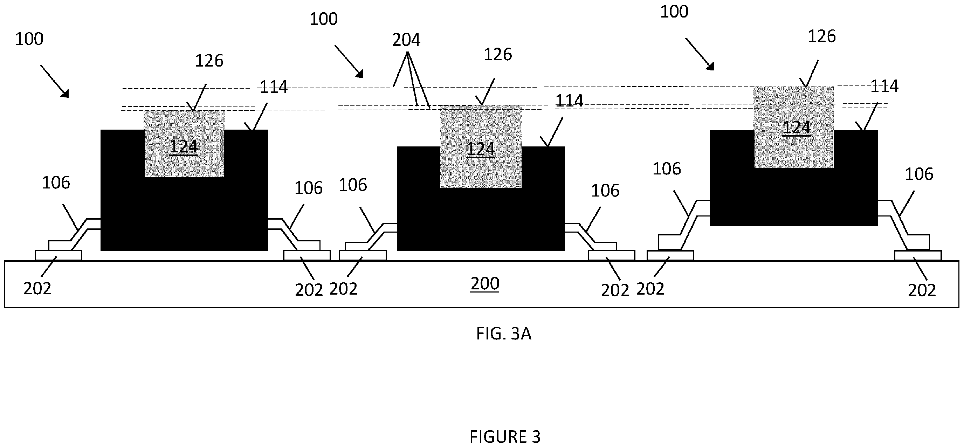

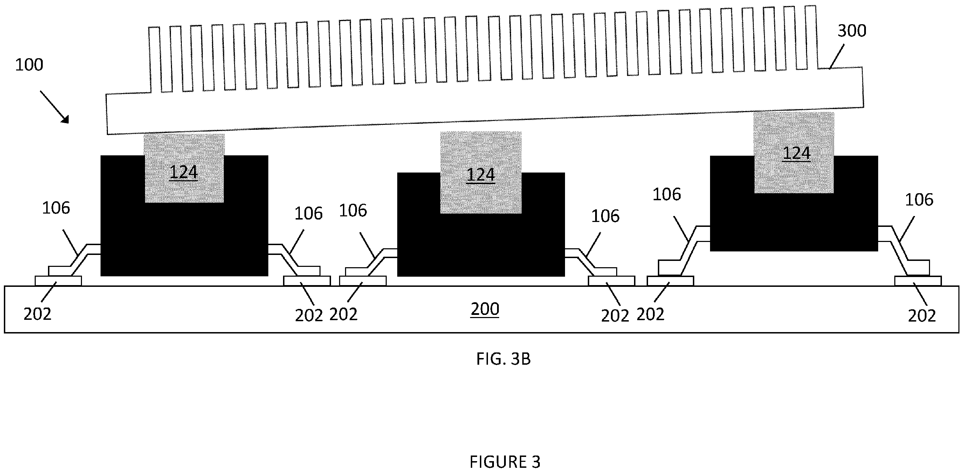

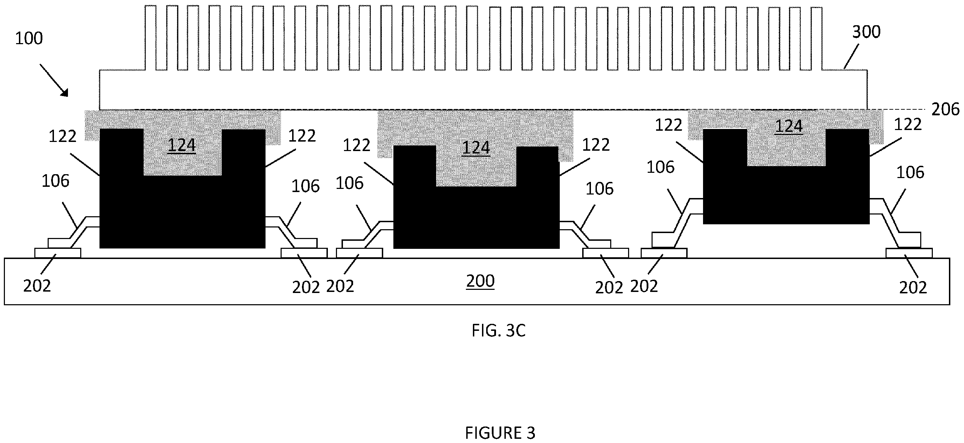

Referring to Fig. 3A, a method of assembling an electronics device comprises providing a circuit carrier 200. The circuit carrier 200 comprises contact pads 202 disposed on an electrically insulating substrate. The circuit carrier 200 may be a laminate based electronics carrier, such as a printed circuit board (PCB). Alternatively, the circuit carrier may be a a power electronics carrier, such as a Direct Copper Bonding (DCB) substrate, a Direct Aluminum Bonding (DAB) substrate, or an Active Metal Brazing (AMB) substrate.

The method comprises providing a plurality of the semiconductor packages 100 that comprise the insert 124 arranged within the recess 112. The semiconductor packages 100 are arranged on the circuit carrier 200 with the package leads 106 facing the contact pads 202. A joining material, such as a solder, sinter, conductive glue may be provided between the package leads 106 and the contact pads 202 to effectuate a mechanical and electrical connection therebetween. According to an embodiment, a pre-reacted solder material such as a solder paste comprising a tin based and/or lead-free solder material is provided between the package leads 106 and the contact pads 202. The semiconductor packages 100 can be mounted and attached to the carrier by performing a heating process whereby the temperature of the solder material is elevated to melt the material and induce a reaction whereby a stable soldered joint is formed. A peak temperature of this heating process occurs at a reflow phase of this heating process. Reflow temperatures for this soldering process may be in the range of 200°C to 300°C, for example.

The semiconductor packages 100 are arranged with the outer upper sides 114 of each of the encapsulant bodies facing away from the circuit carrier 200. As a result, the inserts 124 from each of the semiconductor packages 100 form an uppermost contact point from above the plurality of the semiconductor packages 100. According to an embodiment, the upper sides 126 of the inserts 124 are arranged at different heights relative to the upper side of the circuit carrier 200. That is, as between the various semiconductor packages 100 from the plurality, the uppermost contact points are disposed at different vertical separation distance from the circuit carrier 200. Figure 3 shows three different planes 204 that are arranged at different heights relative to the upper side of the circuit carrier 200 and correspond to the uppermost contact point of each of the semiconductor packages 100. The different heights of the planes 204 can be for a variety of reasons. For example, the different heights can be present as between two semiconductor packages 100 that are supposed to have identical geometric specifications, but actually have a small difference in geometry, e.g., due to process variation. The leftmost pair of semiconductor packages 100 illustrate one example of two semiconductor packages 100 that are nominally identical but in fact the inserts 124 extend to two different planes 204 that are separated from one another. This difference in height may be up to 10µm, up to 200 µm, or up to 600 µm, for example. In another example, the different heights can be attributable to semiconductor packages 100 with different geometric specifications and/or package type, wherein the difference in heights is within the acceptable window to perform the heat sink attachment process to be described below. This difference in height may be up to 50µm, for example. The rightmost semiconductor package 100 illustrates an example of this possibility, wherein this package has a different standoff height as the two leftmost semiconductor packages 100.

Referring to Fig. 3B, a heat sink 300 is arranged over the plurality of semiconductor packages 100 such that the heat sink contacts at least some of the inserts 124. The heat sink 300 is a thermally conductive structure that is configured to radiate heat away from multiple semiconductor packages 100. The heat sink 300 may be formed of a thermally conductive metal, e.g., copper, aluminum, etc. At this stage, the curable polymer compound from each of the inserts 124 is still in an uncured state. Due to the difference in heights between the upper sides 126 of the inserts 124 and the circuit carrier 200, the heat sink 300 may not necessarily contact each one of the inserts 124, and instead only contacts the highest inserts 124 from the plurality. Moreover, the heat sink 300 may not be precisely level and/or parallel to the upper surface of the circuit carrier 200 due to the to the difference in heights. Depending on the viscosity of the material from each of the inserts 124 while in an uncured state, some flow of the material from the inserts 124 is possible such that the heat sink 300 settles at this time. In the case of harder material from the inserts 124, there may be little or no flow of the material from the inserts 124 at this time.

Referring to Fig. 3C, the heat sink 300 is joined to each of the inserts 124 to form a thermally coupled connection between the heat sink 300 and each of the semiconductor packages 100. The joining process redistributes the material from the inserts 124 such that the heat sink 300 contacts at least some of the inserts 124. As shown, the heat sink 300 contacts the material from each one of the inserts. Depending on the package height and amount of material in the inserts 124, the heat sink 300 may directly contact the upper side 114 of the encapsulant body 110 in some embodiments. The inserts 124 form a thermal conduction path between the planar metal pads 104 from each of the semiconductor packages 100 and the heat sink 300. The material from the inserts 124 can be tailored for increased thermal conductivity, e.g., through appropriate selection of the filler materials. The thermal conductivity of the inserts 124 can be higher than that of the material which forms the encapsulant body 110, which does not require thermal conductivity. In this way, an advantageous bifurcation of the materials of the semiconductor package 100 is realized, wherein the thermally beneficial properties are relegated to the element that accommodates the thermal load (i.e., the insert 124) and other beneficial properties are selected for the encapsulant body 110, e.g., cost, dielectric strength, etc.

During the joining process, the material of the inserts 124 may have a liquid or semi-liquid viscosity so as to enable the lateral flow of the insert 124 material away from the recess 112 and towards the outer edge sides 122 of the encapsulant body 110. For example, during the joining process, the material of the inserts 124 may have a dynamic viscosity in the range of 1,000 mPa*s (millipascal seconds) to 50,000 mPa*s. More particularly, the material of the inserts 124 may have a dynamic viscosity in the range of 5,000 mPa*s to 15,000 mPa*s at this time, which roughly resembles the viscosity of honey at room temperature. The material from the inserts 124 can be heated to obtain the proper viscosity during the joining process, and a specific example of which will be described in further detail below. Alternatively, the material from the inserts 124 can have the proper viscosity at room temperature. This may be obtained through proper selection of the filler materials, for example. The viscous flow of the insert 124 material may result from the natural weight of the heat sink 300. Alternatively, direct force may be applied to the heat sink 300 to induce or aid in the flow of the material.

According to an embodiment, the joining process comprises forming an interface between the lower side of the heat sink 300 and the insert 124 material from each of the semiconductor packages 100 that extends along a single plane 206. Thus, in the case that upper sides 126 of the inserts 124 are arranged at different heights, the joining process redistributes the insert 124 material in such a way to form a flat interface that extends along the single plane 206 and connects the heat sink 300 to the insert 124 material from each of the semiconductor packages 100. The flat interface between the lower side of the heat sink 300 and the insert 124 material from each of the semiconductor packages 100 may be leveled and/or substantially parallel to the upper side of the circuit carrier 200. The joining process redistributes the insert 124 material such that the volume of insert 124 material displaced is greatest in the semiconductor packages 100 with the highest vertical distance from the circuit carrier 200 and is lowest in the semiconductor packages 100 with the lowest vertical distance from the circuit carrier 200. In this way, the insert 124 concept provides a buffer region at the upper side of each of the semiconductor packages 100 that absorbs any discrepancy in package height and ensures that a multi-chip heat sink 300 structure can be mated with a plurality of semiconductor packages 100 notwithstanding this discrepancy. This buffer region can accommodate discrepancies in package height of 50 µm, 100 µm, or more.

According to an embodiment, the joining process comprises pushing the material from the inserts 124 through the overflow channels 116. The liquid or semi-liquid state of the insert 124 material allows it to flow through the overflow channels 116 and into the exterior environment. The presence of the overflow channels 116 in the semiconductor packages 100 can therefore advantageously aid in the heat sink 300 attachment process by providing regions for the excess insert 124 material to accumulate and by providing conduits for the insert 124 material to reach the lateral space outside of the semiconductor packages 100. Thus, the amount of discrepancy in vertical height that can be tolerated, can advantageously be increased by the overflow channels 116. Furthermore, the overflow channels 116 ensure that the distance of the planar metal pad 104 that is closest to the heat sink 300 will be minimized and close to the height of the recess. By controlling this distance, a favorable tradeoff between thermal resistance and electrical isolation can be obtained. That is, a minimum amount of insulation material necessary to isolate the planar metal pad 104 from the heat sink 300 can be realized. In addition to flowing the material from the inserts 124, the joining process may comprise curing the curable polymer compound from each of the inserts 124, thereby forming a hardened plastic structure that securely affixes the heat sink 300 to each of the semiconductor packages 100. The curing of the curable polymer compound comprises providing the appropriate stimulus to cross-link the polymers according to the type of curable polymer compound. Thus, the curing process may comprise applying heat in the case of a thermoset material, applying UV radiation in the case of a UV curable material, applying moisture to the material in the case of a moisture-cure polymer compound, applying a catalyst in the case of a catalytic polymer, and so forth.

According to an embodiment, each of the inserts 124 comprises a thermoset polymer in a solid or viscous form and the joining process comprises performing a heat treatment that melts the thermoset polymer to induce the flowing of the material from the inserts 124 laterally away from the recesses and cures the thermoset polymer. That is, a combined step is formed that liquifies the insert 124 material, thereby redistributing the insert 124 material in the above-described manner, and simultaneously induces the reaction that cross-links the polymers to cure the material. In this case, the material from the inserts 124 can be tailored such that a curing temperature of the material obtains the above-described dynamic viscosity to induce flow of the material. This may be done through appropriate selection of filler materials, for example. The material hardens due to the cross-linkage to form a stable plastic interface between each of the semiconductor packages 100 and the heat sink 300.

According to an embodiment, the heat treatment that melts the thermoset polymer is part of a combined process that that reflows the solder material between the package leads 106 and the contact pads 202. That is, a single heat treatment is performed that melts and cures the thermoset polymer as described above, and additionally solders the semiconductor packages 100 to the circuit carrier 200. This may be done by tailoring the thermoset polymer to have a curing temperature and desired melt viscosity that coincides with the reflow temperature of the solder material.

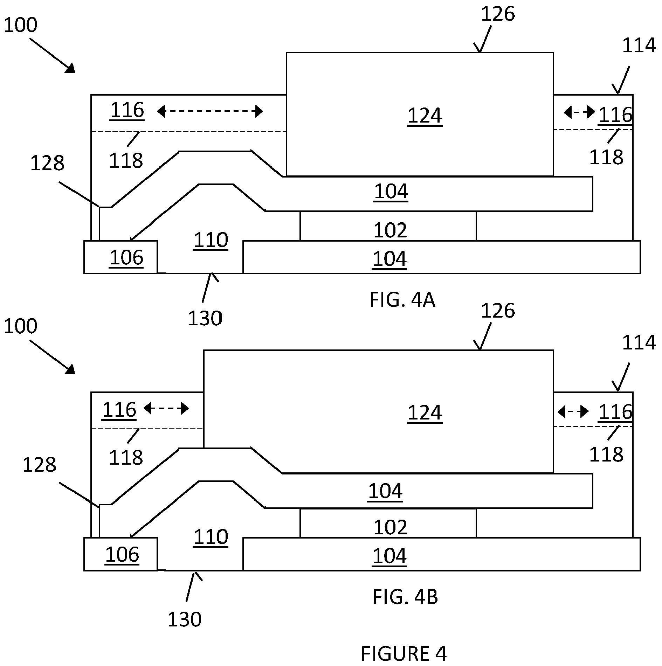

Referring to Figure 4, the semiconductor package 100 is depicted, according to two different embodiments. In these embodiments, the planar metal pad 104 that is thermally coupled to the semiconductor die 102 is provided as part of a metal interconnect clip 128. In the embodiment of Fig. 4A, the insert 124 interfaces with only the planar metal pad 104 portion of the interconnect clip 128. In the embodiment of Fig. 4B, the recess 112 is arranged such that the insert 124 interfaces with a bridge portion of the metal interconnect clip 128, which may facilitate a more central arrangement of the insert 124 for more even flow of insert material to either side.

The semiconductor package 100 of Figure 4 comprises a lead frame that comprises a lead 106 and a second planar metal pad 104 that forms a die pad of the lead frame. The lead 106 and the second planar metal pad 104 are exposed at an outer lower side 130 of the encapsulant body 110. The metal interconnect clip 128 electrically connects an upper surface terminal of the semiconductor die 102 with the lead 106. A lower surface thermal of the semiconductor die, e.g., source, drain, collector, emitter, etc., can be electrically connected to the second planar metal pad 104, which in turn may form a package terminal. The arrangements of Figs. 4A and 4B each provide a double-sided cooling arrangement wherein the semiconductor package 100 can be thermally coupled to a heat sink 300 using the insert 124 in the manner described with reference to Fig. 3A at an upper side of the semiconductor package 100, and the semiconductor package 100 can be thermally coupled to a second heat sink or power electronics carrier at a lower side of the semiconductor package 100 via the second planar metal pad 104.

Referring to Figure 5, the semiconductor package 100 is depicted, according to another embodiment. In this embodiment, the semiconductor package 100 comprises a second planar metal pad 104 that is thermally coupled to the semiconductor die 102, and a second recess 112 that extends from an outer lower side 130 of the encapsulant body 110 towards a rear side of the second planar metal pad 104. The second planar metal pad 104 can serve as a die pad that is electrically connected to an upper surface terminal of the semiconductor die and one of the package leads 106 by an interconnect element such as a bond wire 108. A lower surface terminal of the semiconductor die 102 can be electrically connected to one of the leads 106 by a continuous structure that also comprises the first metal pad. The semiconductor package further comprises a second 124 insert arranged within the second recess 112 that is thermally coupled to the second planar metal pad 104 and extends to the outer lower side 130 of the encapsulant body 110. The second insert 124 may have the same material composition as the first insert 124 according to any of the embodiments as described above. This embodiment provides a double-sided cooling arrangement wherein the semiconductor package 100 can be thermally coupled to a heat sink 300 using the insert 124 in the manner described with reference to Fig. 3A at an upper side of the semiconductor package 100, and the semiconductor package 100 can be thermally coupled to a second heat sink or power electronics carrier at a lower side of the semiconductor package 100 via the second planar metal pad 104 and the second insert 104.

Example 1. A semiconductor package, comprising: a semiconductor die thermally coupled to a planar metal pad; an encapsulant body that encapsulates the semiconductor die and comprises a recess that extends from an outer upper side of the encapsulant body towards a rear side of the planar metal pad; and an insert arranged within the recess that is thermally coupled to the planar metal pad and extends to the outer upper side of the encapsulant body, wherein the insert that is arranged within the recess comprises a curable polymer compound.

Example 2. The semiconductor package of example 1, wherein the curable polymer compound comprises a matrix of pre-polymerized resin combined with a thermally conductive filler.

Example 3. The semiconductor package of example 2, wherein the encapsulant body comprises a mold compound, and wherein the insert has a greater thermal conductivity than the mold compound.

Example 4. The semiconductor package of example 1, wherein the insert protrudes past the outer upper side of the encapsulant body by an amount between 50µm and 250µm.

Example 5. The semiconductor package of example 1, wherein the electrically insulating encapsulant body comprises one or more overflow channels, wherein the one or more overflow channels each extend vertically into the encapsulant body from the outer upper side of the encapsulant body and extend laterally from the sidewalls of the recess to the outer edge sides of the encapsulant body.

Example 6. The semiconductor package of example 5, wherein a depth of the one or more overflow channels is no greater than twenty five percent of a depth of the recess.

Example 7. The semiconductor package of example 5, wherein the electrically insulating encapsulant body comprises a plurality of the overflow channels, wherein the overflow channels form an open passage between an upper region of the recess and each outer edge side of the encapsulant body.

Example 8. The semiconductor package of example 1, wherein the rear side of the planar metal pad is exposed at a bottom of the recess and the insert directly contacts the rear side of the planar metal pad.

Example 9. The semiconductor package of example 1, wherein the planar metal pad is a metal die pad that is electrically isolated within the encapsulant body, wherein the semiconductor die is mounted on the metal die pad with upper surface terminals facing away from the metal die pad, and wherein the semiconductor package comprises leads that are electrically connected to the upper surface terminals.

Example 10. The semiconductor package of example 1, wherein the planar metal pad is an interconnect clip, wherein the semiconductor package comprises a lead that is exposed at an outer lower side of the encapsulant body, and wherein the interconnect clip electrically connects an upper surface terminal of the semiconductor die with the lead.

Example 11. The semiconductor package of example 1, wherein the semiconductor package further comprises: a second planar metal pad that is thermally coupled to the semiconductor, a second recess that extends from an outer lower side of the encapsulant body towards a rear side of the second planar metal pad, a second insert arranged within the second recess that is thermally coupled to the second planar metal pad and extends to the outer lower side of the encapsulant body, wherein the second insert comprises a curable polymer compound.

Example 12. A method of forming a semiconductor package, the method comprising: thermally coupling a semiconductor die to a planar metal pad ; forming an encapsulant body that encapsulates the semiconductor die and comprises a recess that extends from an outer upper side of the encapsulant body towards a rear side of the planar metal pad; and providing an insert within the recess that is thermally coupled to the planar metal pad and extends to the outer upper side of the encapsulant body, wherein the insert that is arranged within the recess comprises a curable polymer compound.

Example 13. The method of example 12, wherein providing the insert within the recess comprises: providing a mixture of material that comprises a matrix of pre-polymerized resin combined with a thermally conductive filler; and filling the recess with the mixture of material.

Example 14. The method of example 13, wherein providing the insert within the recess further comprises: heating the mixture of material to a temperature that is below a curing temperature of the matrix but increases the viscosity of the mixture to reach a semi-liquid state; and filling the recess with the mixture of material in the semi-liquid state.

Example 15. The method of example 13, wherein the electrically insulating encapsulant body comprises one or more overflow channels, each extend vertically into the encapsulant body from the outer upper side of the encapsulant body and extend laterally from the sidewalls of the recess to the outer edge sides of the encapsulant body, and wherein the mixture of material is provided within the one or more overflow channels.

Example 16. A method of assembling an electronics device, the method comprising: providing a plurality of semiconductor packages, each of the semiconductor packages comprising a semiconductor die thermally coupled to a planar metal pad, an encapsulant body that encapsulates the semiconductor die, a plurality of leads exposed from the encapsulant body, a recess that extends from an outer upper side of the encapsulant body towards a rear side of the planar metal pad, and an insert arranged within the recess that is thermally coupled to the planar metal pad and extends to the outer upper side of the encapsulant body; providing a circuit carrier that comprises a plurality of contact pads disposed on an upper side of the circuit carrier; arranging the plurality of semiconductor packages on the circuit carrier with the leads facing the contact pads and with the outer upper sides of each of the encapsulant bodies facing away from the circuit carrier; arranging a heat sink over the plurality of semiconductor packages such that the heat sink contacts at least some of the inserts; and joining the heat sink to each of the inserts so as to form a thermally coupled connection between the heat sink and each of the semiconductor packages, wherein joining the heat sink to each of the inserts comprises flowing material from the inserts laterally away from the recesses.

Example 17. The method of example 16, wherein the joining process comprises forming an interface between the lower side of the heat sink and the insert material from each of the semiconductor packages that extends along a single plane.

Example 18. The method of example 16, wherein before arranging the heat sink over the plurality of semiconductor packages, the upper sides of the inserts are arranged at different heights relative to the upper side of the circuit carrier.

Example 19. The method of example 16, wherein inserts from each of the semiconductor packages comprises a curable polymer compound, and wherein joining the heat sink to each of the inserts comprises curing the curable polymer compound from each of the inserts.

Example 20. The method of example 16, wherein each of the inserts comprises a thermoset polymer, wherein joining the heat sink to each of the inserts comprises performing a heat treatment, and wherein the heat treatment melts the thermoset polymer to induce the flowing of the material from the inserts laterally away from the recesses and cures the thermoset polymer.

Example 21. The method of example 16, wherein the plurality of semiconductor packages is arranged on the circuit carrier with solder material between the leads and the contact pads, and wherein the heat treatment is a combined process that reflows the solder material and melts the material from the inserts.

Example 22. The method of example 16, wherein the electrically insulating encapsulant body comprises a plurality of the overflow channels, wherein the overflow channels form an open passage between an upper region of the recess and each outer edge side of the encapsulant body, and wherein flowing the material from the inserts to form a level interface comprises pushing the material from the inserts through the overflow channels.

Example 23. The method of example 16, wherein before joining the heat sink to each of the inserts the upper sides of the inserts are arranged at different heights relative to the upper side of the circuit carrier, and wherein joining the heat sink to each of the inserts forms an interface between the lower side of the heat sink and the insert material from each of the semiconductor packages that extends along a single plane.

The semiconductor dies disclosed herein can be formed in a wide variety of device technologies that utilize a wide variety of semiconductor materials. Examples of such materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AllnN), indium gallium nitride (InGaN), aluminum gallium indium nitride (AIGalnN) or indium gallium arsenide phosphide (InGaAsP), etc.

The semiconductor dies disclosed herein may be configured as a vertical device, which refers to a device that conducts a load current between opposite facing main and rear surfaces of the die. Alternatively, the semiconductor dies may be configured as a lateral device, which refers to a device that conducts a load current parallel to a main surface of the die.

Spatially relative terms such as "under," "below," "lower," "over," "upper" and the like, are used for ease of description to explain the positioning of one element relative to a second element. These terms are intended to encompass different orientations of the device in addition to different orientations than those depicted in the figures. Further, terms such as "first," "second," and the like, are also used to describe various elements, regions, sections, etc. and are also not intended to be limiting. Like terms refer to like elements throughout the description.

As used herein, the terms "having," "containing," "including," "comprising" and the like are open-ended terms that indicate the presence of stated elements or features, but do not preclude additional elements or features. The articles "a," "an" and "the" are intended to include the plural as well as the singular, unless the context clearly indicates otherwise.

With the above range of variations and applications in mind, it should be understood that the present invention is not limited by the foregoing description, nor is it limited by the accompanying drawings. Instead, the present invention is limited only by the following claims and their legal equivalents.

## Claims

1. A semiconductor package, comprising:
a semiconductor die thermally coupled to a planar metal pad;
an encapsulant body that encapsulates the semiconductor die and comprises a recess that extends from an outer upper side of the encapsulant body towards a rear side of the planar metal pad; and
an insert arranged within the recess that is thermally coupled to the planar metal pad and extends to the outer upper side of the encapsulant body,
wherein the insert that is arranged within the recess comprises a curable polymer compound.

2. The semiconductor package of claim 1, wherein the curable polymer compound comprises a matrix of pre-polymerized resin combined with a thermally conductive filler.

3. The semiconductor package of claim 1 or 2, wherein the encapsulant body comprises a mold compound, and wherein the insert has a greater thermal conductivity than the mold compound.

4. The semiconductor package of one of the preceding claims, wherein the insert protrudes past the outer upper side of the encapsulant body by an amount between 50µm and 250µm.

5. The semiconductor package of one of the preceding claims, wherein the electrically insulating encapsulant body comprises one or more overflow channels, wherein the one or more overflow channels each extend vertically into the encapsulant body from the outer upper side of the encapsulant body and extend laterally from the sidewalls of the recess to the outer edge sides of the encapsulant body.

6. The semiconductor package of claim 5, wherein a depth of the one or more overflow channels is no greater than twenty five percent of a depth of the recess.

7. The semiconductor package of claim 5 or 6, wherein the electrically insulating encapsulant body comprises a plurality of the overflow channels, wherein the overflow channels form an open passage between an upper region of the recess and each outer edge side of the encapsulant body.

8. The semiconductor package of one of the preceding claims, wherein the rear side of the planar metal pad is exposed at a bottom of the recess and the insert directly contacts the rear side of the planar metal pad.

9. The semiconductor package of one of the preceding claims, wherein the planar metal pad is a metal die pad that is electrically isolated within the encapsulant body, wherein the semiconductor die is mounted on the metal die pad with upper surface terminals facing away from the metal die pad, and wherein the semiconductor package comprises leads that are electrically connected to the upper surface terminals.

10. The semiconductor package of one of the preceding claims, wherein the planar metal pad is an interconnect clip, wherein the semiconductor package comprises a lead that is exposed at an outer lower side of the encapsulant body, and wherein the interconnect clip electrically connects an upper surface terminal of the semiconductor die with the lead.

11. The semiconductor package of one of the preceding claims, wherein the semiconductor package further comprises:
a second planar metal pad that is thermally coupled to the semiconductor die;
a second recess that extends from an outer lower side of the encapsulant body towards a rear side of the second planar metal pad; and
a second insert arranged within the second recess that is thermally coupled to the second planar metal pad and extends to the outer lower side of the encapsulant body,
wherein the second insert comprises a curable polymer compound.

12. A method of forming a semiconductor package, the method comprising:
thermally coupling a semiconductor die to a planar metal pad;
forming an encapsulant body that encapsulates the semiconductor die and comprises a recess that extends from an outer upper side of the encapsulant body towards a rear side of the planar metal pad; and
providing an insert within the recess that is thermally coupled to the planar metal pad extends to the outer upper side of the encapsulant body,
wherein the insert that is arranged within the recess comprises a curable polymer compound.

13. The method of claim 12, wherein providing the insert within the recess comprises:
providing a mixture of material that comprises a matrix of pre-polymerized resin combined with a thermally conductive filler; and
filling the recess with the mixture of material.

14. The method of claim 13, wherein providing the insert within the recess further comprises:
heating the mixture of material to a temperature that is below a curing temperature of the matrix but increases the viscosity of the mixture to reach a semi-liquid state; and
filling the recess with the mixture of material in the semi-liquid state.

15. The method of claim 13 or 14, wherein the electrically insulating encapsulant body comprises one or more overflow channels, each extend vertically into the encapsulant body from the outer upper side of the encapsulant body and extend laterally from the sidewalls of the recess to the outer edge sides of the encapsulant body, and wherein the mixture of material is provided within the one or more overflow channels.
